# EUROPÄISCHE PATENTSCHRIFT

(11) **EP 2 989 666 B1**
(45) Veröffentlichungstag und Bekanntmachung des Hinweises auf die Patenterteilung: **31.05.2017**
(21) Anmeldenummer: 14716864.5
(22) Anmeldetag: 14.04.2014
(51) Int. Cl.: H01L 33/56, H01L 33/10, H01L 33/28, H01L 33/44, H01L 33/64

(54) **OPTOELEKTRONISCHES BAUELEMENT UND VERFAHREN ZU SEINER HERSTELLUNG**
OPTOELECTRONIC COMPONENT AND METHOD FOR THE PRODUCTION THEREOF
COMPOSANT OPTOÉLECTRONIQUE ET PROCÉDÉ DE FABRICATION

(30) Priorität: 25.04.2013 DE 102013104195
(43) Veröffentlichungstag der Anmeldung: 02.03.2016
(73) Patentinhaber: OSRAM Opto Semiconductors GmbH, 93055 Regensburg (DE)
(72) Erfinder: DIRSCHERL, Georg, 93105 Tegernheim (DE)
(74) Vertreter: Epping - Hermann - Fischer
(86) Internationale Anmeldenummer: PCT/EP2014/057523
(87) Internationale Veröffentlichungsnummer: WO 2014/173719

(56) Entgegenhaltungen:
- EP-A2- 1 178 544
- US-A1- 2003 189 830

## Beschreibung

Die vorliegende Erfindung betrifft ein Verfahren zum Herstellen eines optoelektronischen Bauelements sowie ein optoelektronisches Bauelement.

Die Druckschrift DE 102010027253 A1 beschreibt ein optoelektronisches Bauelement.

1178544 offenbart ein optoelektronisches Bauelement, welches eine erste Lage eines polymeren Materials, eine adhäsive Lage und eine zweite Lage eines polymeren Materials aufweist.

US2003/189830 offenbart zusätzlich eine adhäsive Lage aus einem Flüssigkristallmaterial. Eine zu lösende Aufgabe besteht darin, ein Verfahren zum Herstellen eines optoelektronischen Bauelements anzugeben. Eine weitere zu lösende Aufgabe besteht darin, ein optoelektronisches Bauelement bereitzustellen.

Mit den hier beschriebenen Verfahren kann insbesondere ein hier beschriebenes optoelektronisches Bauelement hergestellt werden. D. h., sämtliche für das Verfahren offenbarten Merkmale sind auch für das optoelektronische Bauelement offenbart und umgekehrt.

Bei hier beschriebenen optoelektronischen Bauelementen können polymere Materialien vielfache Verwendung finden. Beispielsweise können Silikone als Gehäusematerial, als Vergussmaterial und zur Herstellung von Linsen verwendet werden. Viele polymere Materialien, weisen allerdings eine geringe Haftung auf. Hierdurch kann es zu einer Ablösung von Silikonlagen oder einer Trennung aneinandergefügter Silikonschichten kommen. Auch durch Temperatureinflüsse, mechanischen Stress oder Feuchtigkeit kann es zu einer Delamination von Silikonschichten kommen.

Es ist möglich, Silikonoberflächen mit Plasma, beispielsweise Sauerstoffplasma, zu behandeln, um die Silikonoberflächen reaktiver zu machen. Allerdings hält eine derartige Plasmaaktivierung nur kurze Zeit an, bevor sie wiederholt werden muss. Zudem kann eine Plasmabehandlung zu einer chemischen Modifizierung einer Silikonoberfläche führen, was eine Degradation des Silikons zur Folge haben kann.

Ein Verfahren zum Herstellen eines optoelektronischen Bauelements umfasst Schritte zum Erzeugen einer ersten Lage eines polymeren Materials, zum Aufbringen von Kristallen auf eine Oberfläche der ersten Lage, und zum Erzeugen einer zweiten Lage eines polymeren Materials auf der Oberfläche der ersten Lage. Vorteilhafterweise wirken die auf die Oberfläche der ersten Lage aufgebrachten Kristalle als Anker zwischen der ersten Lage und der zweiten Lage. Hierdurch wird eine verbesserte, durch Verankerung erzielte, Adhäsion zwischen der ersten Lage und der zweiten Lage erreicht. Vorteilhafterweise ist dabei keine chemische Veränderung, und damit auch keine Degradation, der Oberfläche der ersten Lage erforderlich. Ein weiterer Vorteil kann in einer verbesserten Wärmeleitung zwischen der ersten Lage und der zweiten Lage bestehen.

In einer Ausführungsform des Verfahrens weisen die Kristalle eine konkave Form auf. Vorteilhafterweise können die Kristalle dann eine besonders wirksame Verankerung zwischen der ersten Lage und der zweiten Lage bewirken.

In einer Ausführungsform des Verfahrens werden die Kristalle vor einem Aushärten des Materials der ersten Lage aufgebracht. Vorteilhafterweise können die Kristalle dann teilweise in das Material der ersten Lage einsinken, wodurch eine besonders wirksame Verankerung zwischen der ersten Lage und der zweiten Lage bewirkt werden kann.

In einer Ausführungsform des Verfahrens wird die zweite Lage vor einem Aushärten des Materials der ersten Lage erzeugt. Vorteilhafterweise kann durch ein gemeinsames Aushärten des Materials der ersten Lage und des Materials der zweiten Lage eine besonders dauerhafte Verbindung zwischen der ersten Lage und der zweiten Lage erreicht werden.

In einer Ausführungsform des Verfahrens werden die Kristalle durch einfaches Aufstreuen aufgebracht. Hierdurch kann das Verfahren vorteilhafterweise besonders einfach und kostengünstig durchgeführt werden.

In einer Ausführungsform des Verfahrens werden die Kristalle ohne Verwendung eines Dispersions-Additivs aufgebracht. Auch hierdurch kann das Verfahren vorteilhafterweise besonders einfach und kostengünstig durchgeführt werden.

Ein optoelektronisches Bauelement weist eine erste Lage eines polymeren Materials und eine zweite Lage eines polymeren Materials auf. Dabei grenzen die erste Lage und die zweite Lage aneinander an. In einem Kontaktbereich zwischen der ersten Lage und der zweiten Lage sind Kristalle angeordnet. Vorteilhafterweise bewirken die Kristalle eine Verankerung zwischen der ersten Lage und der zweiten Lage, wodurch sich eine verbesserte Haftung der zweiten Lage an der ersten Lage ergibt. Dadurch wird vorteilhafterweise eine Delamination der zweiten Lage von der ersten Lage verhindert. Vorteilhafterweise ist hierzu keine chemische Modifizierung und damit auch keine Degradation der Oberfläche der ersten Lage erforderlich. Ein weiterer Vorteil kann in einer verbesserten Wärmeleitung zwischen der ersten Lage und der zweiten Lage bestehen.

In einer Ausführungsform des optoelektronischen Bauelements weisen die Kristalle eine konkave Form auf. Vorteilhafterweise können die Kristalle dann eine besonders wirksame Verankerung der zweiten Lage an der ersten Lage bewirken.

In einer Ausführungsform des optoelektronischen Bauelements weist die erste Lage und/oder die zweite Lage ein Silikon auf. Vorteilhafterweise kann durch die zwischen der ersten Lage und der zweiten Lage angeordneten Kristalle eine niedrige Haftfähigkeit des Silikons ausgeglichen werden.

In einer Ausführungsform des optoelektronischen Bauelements weist die erste Lage und/oder die zweite Lage Polytetrafluorethylen auf. Vorteilhafterweise kann durch die zwischen der ersten Lage und der zweiten Lage angeordneten Kristalle eine niedrige Haftfähigkeit des Polytetrafluorethylens ausgeglichen werden.

In einer Ausführungsform des optoelektronischen Bauelements weist die erste Lage und/oder die zweite Lage ein Polyphthalamid (PPA), ein Epoxid-basiertes Duroplast, Polyester oder ein anderes polymeres Material auf. Vorteilhafterweise kann durch die zwischen der ersten Lage und der zweiten Lage angeordneten Kristalle eine niedrige Haftfähigkeit des polymeren Materials ausgeglichen werden.

Gemäß zumindest einer Ausführungsform des Verfahrens sind die erste Lage und die zweite Lage jeweils mit dem gleichen polymeren Material gebildet. Dabei ist es möglich, dass beide Lagen zusätzliche Füllstoffe umfassen, die sich vom polymeren Material unterscheiden. Die Lagen können dabei auch voneinander unterschiedliche Füllstoffe umfassen. So ist es beispielsweise möglich, dass die erste Lage strahlungsstreuende und/oder strahlungsreflektierende Partikel enthält. Die zweite Lage kann beispielsweise strahlungskonvertierende Partikel wie etwa einen Lumineszenzkonversionsstoff enthalten.

Dadurch ist es insbesondere möglich, dass die erste Lage und die zweite Lage, obwohl sie mit dem gleichen polymeren Material gebildet sind, unterschiedliche thermische Ausdehnungskoeffizienten voneinander aufweisen können. D. h. aufgrund der Tatsache, dass zumindest in einer der Lagen ein Füllstoff Verwendung findet, der in der anderen Lage nicht oder kaum vorhanden ist, weisen die Lagen unterschiedliche thermische Ausdehnungskoeffizienten auf.

Dabei ist es insbesondere möglich, dass beide Lagen als polymeres Material Silikon enthalten oder aus Silikon bestehen.

Dem hier beschriebenen Verfahren sowie dem hier beschriebenen optoelektronischen Bauelement liegt dabei unter anderem die Erkenntnis zugrunde, dass unterschiedliche Füllstoffpartikel in unterschiedlichen Lagen die thermischen Eigenschaften der Lagen, insbesondere den thermischen Ausdehnungskoeffizienten, verändern. Aus diesem Grund ist es möglich, dass Lagen, die mit dem gleichen polymeren Grundmaterial, wie beispielsweise Silikon, gebildet sind, ein unterschiedliches thermisches Ausdehnungsverhalten aufweisen können. Es hat sich nun gezeigt, dass die hier beschriebenen Kristalle, insbesondere Kristalle, die eine konkave Form aufweisen, zu einer besseren Haftung auch solcher Lagen untereinander führen können, sodass die Kristalle im Kontaktbereich der beiden Lagen zu einer verringerten Delaminationsleitung unter Zyklenbelastung, d. h. bei wechselnden Temperaturen, führen.

Gemäß zumindest einer Ausführungsform des Verfahrens ist die erste Lage mit strahlungsstreuenden und/oder strahlungsreflektierenden Partikeln gefüllt, welche die erste Lage weiß oder farbig erscheinen lassen. Die zweite Lage ist nominell frei von Füllstoffpartikeln oder mit Partikel eines Konversionsmaterials gefüllt. Beispielsweise kann die erste Lage einen optoelektronischen Halbleiterchip lateral umgeben und beispielsweise bündig mit dessen Oberseite abschließen. Auf die erste Lage und den optoelektronischen Halbleiterchip kann dann die zweite Lage aufgebracht sein, welche in direktem Kontakt mit der ersten Lage stehen kann. Auf diese Weise ist es beispielsweise möglich, den optoelektronischen Halbleiterchip mit einem strahlungsreflektierenden oder farbigen Körper, der durch die erste Lage gebildet ist, zu umgeben. An der Strahlungsaustrittsfläche des Halbleiterchips ist dann die zweite Lage ausgebildet, in die beispielsweise ein Lumineszenzkonversionsmaterial eingebracht ist, das zumindest einen Teil der vom Halbleiterchip im Betrieb erzeugten elektromagnetischen Strahlung wellenlängenkonvertiert. Auf diese Weise kann vom derart hergestellten optoelektronischen Bauelement beispielsweise farbiges oder weißes Mischlicht emittiert werden.

Gemäß zumindest einer Ausführungsform des Verfahrens ist zumindest ein Großteil der Kristalle stellenweise vom Material der ersten Lage und stellenweise vom Material der zweiten Lage umgeben. Dies kann dadurch erreicht sein, dass die Kristalle auf das noch nicht ausgehärtete Material der ersten Lage aufgebracht werden. Die Kristalle sinken dann teilweise, aber nicht vollständig in das Material der ersten Lage ein. Die zweite Lage kann beispielsweise vor dem Aushärten des Materials der ersten Lage aufgebracht werden. Auch das Material der zweiten Lage umgibt den aus der ersten Lage hinausragenden Teil der Kristalle, sodass die Kristalle stellenweise mit dem Material der ersten Lage und stellenweise mit dem Material der zweiten Lage in direktem Kontakt stehen und von diesem jeweils umgeben sind. Beim Aushärten der beiden Lagen kann es dann auch zu Volumenänderungen der Lagen kommen. Beispielsweise schrumpft das Volumen der Lagen, was zusätzlich zu einer noch stärkeren Verzahnung mit den Kristallen führt. "Zumindest ein Großteil der Kristalle" bedeutet dabei, dass wenigstens 50 % der aufgebrachten Kristalle von Material beider Lagen umgeben sind und mit Material beider Lagen stellenweise in direktem Kontakt stehen. Dabei ist es möglich, den Anteil der Kristalle, die vollständig in der ersten Lage versinken, über die Zeit bis zur Aufbringung der zweiten Lage sowie über die Viskosität der ersten Lage einzustellen.

In einer Ausführungsform des optoelektronischen Bauelements weisen die Kristalle eine durchschnittliche Größe von weniger als 0,5 mm, bevorzugt von weniger als 0,2 mm, auf. Vorteilhafterweise ermöglicht eine derart geringe Größe der Kristalle eine Anordnung einer Vielzahl von Kristallen zwischen der ersten Lage und der zweiten Lage auch bei optoelektronischen Bauelementen mit geringen räumlichen Abmessungen.

In einer Ausführungsform des optoeletronischen Bauelements weisen die Kristalle Zinkoxid auf. Vorteilhafterweise eignen sich Zinkoxid-Kristalle zum Herstellen einer mechanischen Verankerung durch Verhaken.

In einer Ausführungsform des optoelektronischen Bauelements sind die Kristalle als Tetrapoden ausgebildet. Vorteilhafterweise bewirken die vier Arme der Kristalle dann eine besonders wirksame Verankerung zwischen der ersten Lage und der zweiten Lage. Solche Kristalle sind in einem anderen Zusammenhang in der Veröffentlichung X. Jin, J. Streuben, L. Heepe, A. Kovalev, Y. K. Mishra, R. Adelung, Adv. Mater. 2012 beschrieben.

In einer Ausführungsform des optoelektronischen Bauelements sind optisch reflektierende Partikel in das Material der ersten Lage eingebettet. Vorteilhafterweise kann die erste Lage dann als optische Reflexionsschicht des optoelektronischen Bauelements dienen.

In einer Ausführungsform des optoelektronischen Bauelements bildet die zweite Lage eine optische Linse des optoelektronischen Bauelements. Vorteilhafterweise kann die Linse eine Kollimation einer durch das optoelektronische Bauelement ausgesandten elektromagnetischen Strahlung bewirken.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Dabei zeigen in jeweils schematisierter Darstellung
- Figur 1: eine perspektivische Darstellung eines Kristalls;
- Figur 2: eine Oberfläche einer polymeren Lage mit teilweise darin eingesunkenen Kristallen;
- Figur 3: eine Schnittdarstellung eines Teils eines optoelektronischen Bauelements gemäß einer ersten Ausführungsform; und
- Figur 4: eine Schnittdarstellung eines optoelektronischen Bauelements gemäß einer zweiten Ausführungsform.

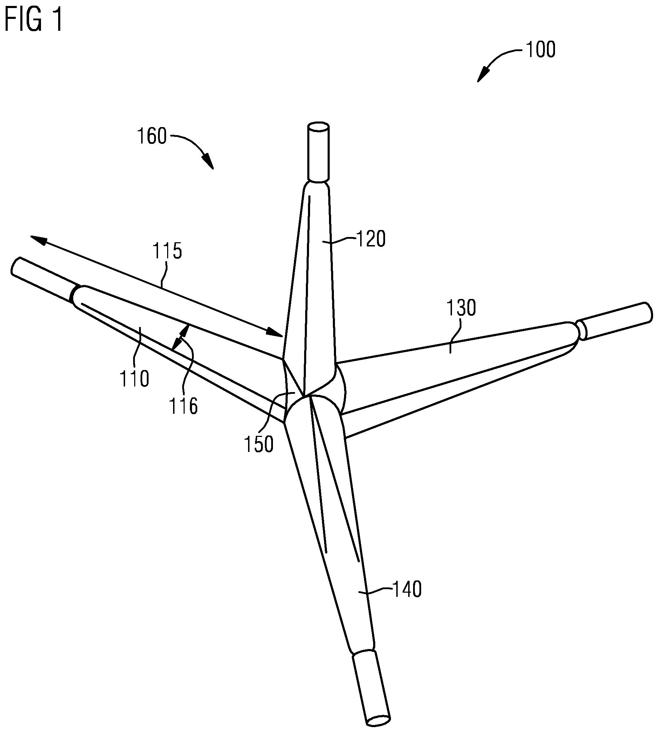

Figur 1 zeigt eine perspektivische Darstellung eines Kristalls 100. Der beispielhaft dargestellte Kristall 100 ist ein Zinkoxidkristall in Form eines Tetrapoden. Der Kristall 100 könnte jedoch auch durch einen Kristall aus einem anderen Material und/oder mit einer anderen Form ersetzt werden.

Der in Form eines Tetrapoden ausgebildete Kristall 100 weist einen ersten Arm 110, einen zweiten Arm 120, einen dritten Arm 130 und einen vierten Arm 140 auf. Der erste Arm 110, der zweite Arm 120, der dritte Arm 130 und der vierte Arm 140 erstrecken sich von einem gemeinsamen Mittelpunkt 150 aus zu den Ecken eines gedachten Tetraeders.

Jeder der vier Arme 110, 120, 130, 140 weist eine Armlänge 115 auf. Die Armlänge 115 kann beispielsweise im Bereich zwischen 10 µm und 100 µm liegen. Jeder der Arme 110, 120, 130, 140 weist einen durchschnittlichen Armdurchmesser 116 auf. Der Armdurchmesser 116 kann beispielsweise zwischen 1 µm und 10 µm liegen. Hieraus ergibt sich eine Gesamtabmessung des Kristalls 100 von weniger als 0,5 mm, bevorzugt von weniger als 0,2 mm. Der Kristall 100 könnte jedoch auch kleiner oder größer ausgebildet sein.

Der in Form eines Tetrapoden ausgebildete Kristall 100 weist eine konkave Form auf. Eine gedachte konkave Hülle 160 kann um den ersten Arm 110, den zweiten Arm 120, den dritten Arm 130 und den vierten Arm 140 des Kristalls 100 gelegt werden.

Wird der Zinkoxid aufweisende Kristall 100 durch einen alternativen Kristall ersetzt, so weist bevorzugt auch der alternative Kristall eine konkave Form auf.

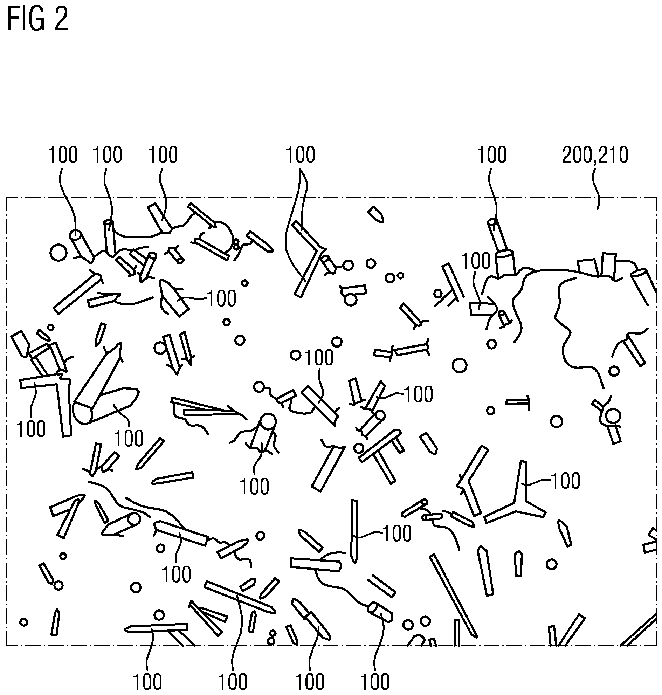

Figur 2 zeigt eine Aufsicht auf eine Oberfläche 210 einer polymeren Lage 200. Die polymere Lage 200 weist ein polymeres Material auf. Beispielsweise kann die polymere Lage 200 ein Silikon aufweisen. Die polymere Lage 200 kann beispielsweise auch Polytetrafluorethylen (PTFE), ein Polyphthalamid (PPA), ein Epoxid-basiertes Duroplast, Polyester oder ein anderes polymeres Material aufweisen. Das Material der polymeren Lage 200 wurde in flüssiger Form aufgebracht. Anschließend ist das Material der polymeren Lage 200 ausgehärtet.

Auf die Oberfläche 210 der polymeren Lage 200 wurde eine Mehrzahl der in Figur 1 dargestellten Kristalle 100 aufgebracht. Die Kristalle 100 sind an der Oberfläche 210 der polymeren Lage 200 teilweise in das Material der polymeren Lage 200 eingesunken. Einzelne Arme 110, 120, 130, 140 der Kristalle 100 ragen an der Oberfläche 210 aus dem Material der polymeren Lage 200 heraus. Andere Arme 110, 120, 130, 140 der Kristalle 100 sind innerhalb der polymeren Lage 200 angeordnet. Hierdurch sind die Kristalle 100 in der polymeren Lage 200 verankert.

Die Kristalle 100 wurden bevorzugt vor dem vollständigen Aushärten des Materials der polymeren Lage 200 auf die Oberfläche 210 der polymeren Lage 200 aufgebracht. Dies erleichtert das teilweise Einsinken der Kristalle 100 in die polymere Lage 200.

Die Kristalle 100 wurden bevorzugt auf die Oberfläche 210 der polymeren Lage 200 aufgestreut. Das Aufstreuen der Kristalle 100 auf die Oberfläche 210 der polymeren Lage 200 kann ohne Dispersions-Additiv erfolgt sein.

In einem nachfolgenden Bearbeitungsschritt kann auf die Oberfläche 210 der polymeren Lage 200 eine weitere Lage aus einem polymeren Material aufgebracht werden. Die über die Oberfläche 210 der polymeren Lage 200 hervorstehenden Arme 110, 120, 130, 140 der an der Oberfläche 210 der polymeren Lage 200 angeordneten Kristalle 100 werden dabei in das polymere Material der weiteren Lage eingebettet und dadurch in der weiteren Lage verankert. Gleichzeitig sind die Kristalle 100 teilweise in das Material der polymeren Lage 200 eingebettet und dadurch in der polymeren Lage 200 verankert. Hierdurch bewirken die Kristalle 100 eine durch Verankerung bzw. durch Verhaken erzielte Adhäsion zwischen der polymeren Lage 200 und der weiteren Lage aus polymerem Material.

Bevorzugt wird die weitere Lage aus polymerem Material auf die Oberfläche 210 der polymeren Lage 200 aufgebracht, bevor das polymere Material der polymeren Lage 200 vollständig ausgehärtet ist. Diese Verarbeitung kann als wet-wet-processing bezeichnet werden. Die polymere Lage 200 und die weitere Lage aus polymerem Material können dann gemeinsam aushärten, wodurch sich eine besonders wirksame Adhäsion zwischen der polymeren Lage 200 und der auf der Oberfläche 210 der polymeren Lage 200 angeordneten weiteren Lage aus polymerem Material ergibt.

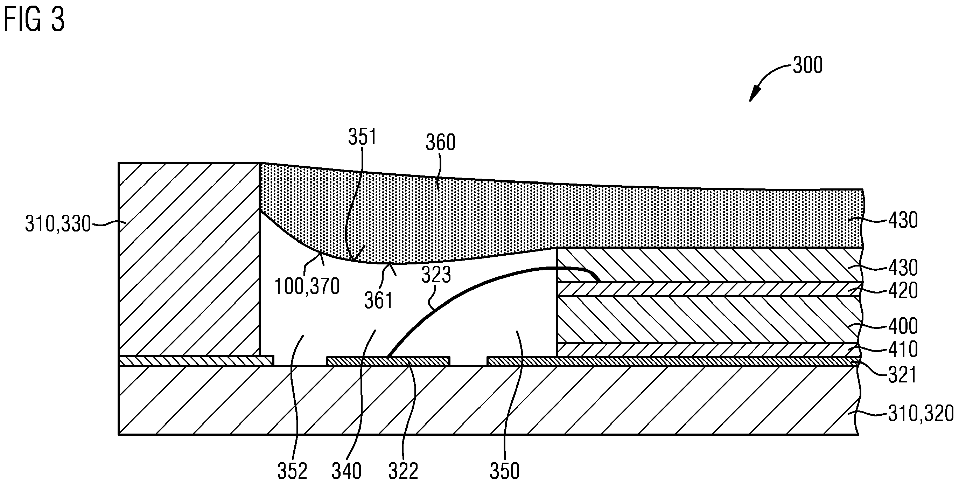

Figur 3 zeigt eine schematische Schnittdarstellung eines Teils eines optoelektronischen Bauelements 300. Das optoelektronische Bauelement 300 kann beispielsweise ein Leuchtdioden-Bauelement sein.

Das optoelektronische Bauelement 300 weist ein Gehäuse 310 auf. Das Gehäuse 310 umfasst einen Boden 320 und einen auf einer Oberseite des Bodens 320 angeordneten umlaufenden Begrenzungsring 330. Der Boden 320 und/oder der Begrenzungsring 330 des Gehäuses 310 können ein keramisches Material aufweisen. Beispielsweise können der Boden 320 und/oder der Begrenzungsring 330 des Gehäuses 310 A1N aufweisen.

Im durch den Begrenzungsring 330 seitlich umgrenzten Bereich oberhalb des Bodens 320 weist das Gehäuse 310 des optoelektronischen Bauelements 300 einen Innenraum 430 auf. Im Bereich des Innenraums 340 sind auf der Oberseite des Bodens 320 eine erste Kontaktfläche 321 und eine zweite Kontaktfläche 322 angeordnet. Die erste Kontaktfläche 321 und die zweite Kontaktfläche 322 weisen jeweils ein elektrisch leitendes Material auf.

Das optoelektronische Bauelement 300 umfasst ferner einen optoelektronischen Halbleiterchip 400. Der optoelektronische Halbleiterchip 400 kann beispielsweise ein Leuchtdioden-Chip (LED-Chip) sein. Der optoelektronische Halbleiterchip 400 ist im Innenraum 340 des Gehäuses 310 des optoelektronischen Bauelements 300 über der ersten Kontaktfläche 321 angeordnet. Zwischen der ersten Kontaktfläche 321 und dem optoelektronischen Halbleiterchip 400 ist eine untere Verbindungsschicht 410 vorgesehen. Die untere Verbindungsschicht 410 kann beispielsweise elektrisch leitend ausgebildet sein. Die untere Verbindungsschicht 410 kann beispielsweise durch eine Lötverbindung gebildet sein.

Im dargestellten Beispiel des optoelektronischen Bauelements 300 ist an einer dem Boden 320 des Gehäuses 310 gegenüberliegenden Oberseite des optoelektronischen Halbleiterchips 400 eine Konversionsschicht 430 angeordnet, die über eine obere Verbindungsschicht 420 mit dem optoelektronischen Halbleiterchip 400 verbunden ist. Die Konversionsschicht 430 kann beispielsweise ein Silikon aufweisen. Die Konversionsschicht 430 kann dazu dienen, eine Wellenlänge einer durch den optoelektronischen Halbleiterchip 400 emitierten elektromagnetischen Strahlung zu konvertieren. Hierzu können in die Konversionsschicht 430 wellenlängenkonvertierende Partikel eingebettet sein. Die obere Verbindungsschicht 420 kann entfallen.

Zwischen der Oberseite des optoelektronischen Halbleiterchips 400 und der zweiten Kontaktfläche 322 am Boden 320 des Gehäuses 310 erstreckt sich ein Bonddraht 323, der eine elektrisch leitende Verbindung zwischen dem optoelektronischen Halbleiterchip 400 und der zweiten Kontaktfläche 322 herstellt.

In einem sich außen um den optoelektronischen Halbleiterchip 400 herum erstreckenden Bereich des Innenraums 340 des Gehäuses 310 des optoelektronischen Bauelements 300 ist eine Reflektorschicht 350 angeordnet. Die Reflektorschicht 350 wird durch den Begrenzungsring 330 des Gehäuses 310, den Boden 320 des Gehäuses 310 und den optoelektronischen Halbleiterchip 400 begrenzt. Eine vom Boden 320 des Gehäuses 310 abgewandte Oberseite 351 der Reflektorschicht 350 schließt etwa bündig mit einer Oberseite der Konversionsschicht 430 ab.

Die Reflektorschicht 350 kann ein Silikon aufweisen. In die Reflektorschicht 350 sind optisch reflektierende Partikel 352 eingebettet. Die in das Material der Reflektorschicht 350 eingebetteten Partikel 352 können beispielsweise TiO2 aufweisen. Der Bonddraht 323 ist in die Reflektorschicht 350 eingebettet, wodurch sich ein Schutz des Bonddrahts 323 vor einer mechanischen Beschädigung ergibt.

Oberhalb der Oberseite 351 der Reflektorschicht 350 und oberhalb der Konversionsschicht 430 ist eine Vergussschicht 360 im Innenraum 340 des Gehäuses 310 des optoelektronischen Bauelements 300 angeordnet. Die Vergussschicht 360 dient als mechanischer Schutz für die Reflektorschicht 350 und die Konversionsschicht 430. Die Vergussschicht 360 kann ein Silikon aufweisen.

Eine Unterseite 361 der Vergussschicht 360 grenzt an die Oberseite 351 der Reflektorschicht 350 an. Zwischen der Oberseite 351 der Reflektorschicht 350 und der Unterseite 361 der Vergussschicht 360 ist somit ein Kontaktbereich 370 gebildet. Im Kontaktbereich 370 ist eine Vielzahl von Kristallen 100 angeordnet. Bevorzugt sind die Kristalle 100 teilweise in die Reflektorschicht 350 und teilweise in die Vergussschicht 360 eingebettet. Die im Kontaktbereich 370 angeordneten Kristalle 100 bewirken eine durch Verankerung erzeugte Adhäsion zwischen der Reflektorschicht 350 und der Vergussschicht 360, wie dies anhand der Figur 2 erläutert wurde. Die im Kontaktbereich 370 zwischen der Reflektorschicht 350 und der Vergussschicht 360 angeordneten Kristalle 100 verbessern dadurch die Anhaftung der Vergussschicht 360 an der Reflektorschicht 350 und verhindern eine Delamination zwischen der Reflektorschicht 350 und der Vergussschicht 360.

Die Kristalle 100 wurden bevorzugt bereits vor dem Aushärten der Reflektorschicht 350 auf die Oberseite 351 der Reflektorschicht 350 aufgebracht. Anschließend wurde die Vergussschicht 360 bevorzugt bereits vor dem Aushärten der Reflektorschicht 350 auf die Oberseite 351 der Reflektorschicht 350 aufgebracht.

Auch im Bereich zwischen der Konversionsschicht 430 und der Vergussschicht 360 können Kristalle 100 angeordnet sein und eine Adhäsion zwischen der Konversionsschicht 430 und der Vergussschicht 360 erhöhen.

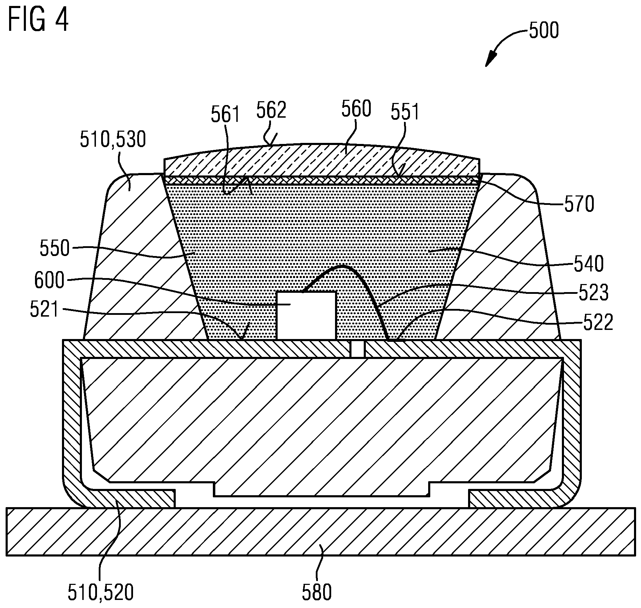

Figur 4 zeigt eine schematische Schnittdarstellung eines optoelektronischen Bauelements 500 gemäß einer zweiten Ausführungsform. Das optoelektronische Bauelement 500 kann beispielsweise ein Leuchtdioden-Bauelement sein.

Das optoelektronische Bauelement 500 weist ein in Figur 4 nur schematisch dargestelltes Gehäuse 510 auf. Das Gehäuse 510 umfasst einen Boden 520. Ein erster Abschnitt des Bodens 520 bildet eine erste elektrische Kontaktfläche 521. Ein zweiter Abschnitt des Bodens 520 bildet eine zweite elektrische Kontaktfläche 522. Das Gehäuse 510 des optoelektronischen Bauelements 500 umfasst ferner einen Begrenzungsring 530, der auf einer Oberseite des Bodens 520 angeordnet ist und einen Innenraum 540 des Gehäuses 510 umlaufend begrenzt. Das Gehäuse 510 des optoelektronischen Bauelements 500 ist auf einem in Figur 4 nur schematisch dargestellten Träger 580 angeordnet.

Im Innenraum 540 des Gehäuses 510 des optoelektronischen Bauelements 500 ist ein optoelektronischer Halbleiterchip 600 auf der ersten Kontaktfläche 521 des Bodens 520 angeordnet. Der optoelektronische Halbleiterchip 600 kann beispielsweise ein LED-Chip sein. Mittels eines Bonddrahts 523 ist der optoelektronische Halbleiterchip 600 elektrisch leitend mit der zweiten Kontaktfläche 522 verbunden.

Der Innenraum 540 des Gehäuses 510 des optoelektronischen Bauelements 500 ist mit einer Vergussschicht 550 gefüllt, in die der optoelektronische Halbleiterchip 600 und der Bonddraht 523 eingebettet sind. Die Vergussschicht 550 dient einem mechanischen Schutz des optoelektronischen Halbleiterchips 600 und des Bonddrahts 523. Die Vergussschicht 550 kann beispielsweise ein Silikon aufweisen und wurde in flüssiger Form in den Innenraum 540 des Gehäuses 510 eingebracht. Eine Oberseite 551 der Vergussschicht 550 schließt etwa bündig mit einer Oberseite des Begrenzungsrings 530 des Gehäuses 510 ab.

An der Oberseite 551 der Vergussschicht 550 des optoeelktronischen Bauelements 500 ist eine Linse 560 angeordnet. Die Linse 560 dient als optische Linse und kann beispielsweise einer Kollimation einer durch den optoelektronischen Halbleiterchip 600 ausgesandten elektromagnetischen Strahlung dienen. Hierzu ist eine von der Vergussschicht 550 abgewandte Außenseite 562 der Linse 560 im dargestellten Beispiel konvex ausgebildet.

Die Linse 560 kann beispielsweise Silikon aufweisen und wurde in flüssiger Form auf die Oberseite 551 der Vergussschicht 550 aufgebracht. Eine Unterseite 561 der Linse 560 ist der Oberseite 551 der Vergussschicht 550 zugewandt. An der Grenze zwischen der Oberseite 551 der Vergussschicht 550 und der Unterseite 561 der Linse 560 ist ein Kontaktbereich 570 ausgebildet. Im Kontaktbereich 570 ist eine Mehrzahl von Kristallen 100 angeordnet, die eine durch Verhakung bzw. Verankerung erzielte Adhäsion zwischen der Vergussschicht 550 und der Linse 560 bewirken, wie dies anhand der Figur 2 erläutert wurde. Die Arme 110, 120, 130, 140 der im Kontaktbereich 570 angeordneten Kristalle 100 sind teilweise in die Vergussschicht 550 und teilweise in die Linse 560 eingebettet. Hierdurch halten die Kristalle 100 die Linse 560 an der Vergussschicht 550.

Bevorzugt wurden die Kristalle 100 durch Aufstreuen auf die Oberseite 551 der Vergussschicht 550 aufgebracht. Bevorzugt wurden die Kristalle 100 bereits vor dem vollständigen Aushärten der Vergussschicht 550 auf die Oberseite 551 der Vergussschicht 550 aufgebracht. Anschließend wurde die Linse 560 auf die Oberseite 551 der Vergussschicht 550 aufgebracht. Bevorzugt erfolgte auch das Aufbringen der Linse 560 bereits vor dem vollständigen Aushärten der Vergussschicht 550. Die Vergussschicht 550 und die Linse 560 sind anschließend gemeinsam ausgehärtet.

Die Erfindung wurde anhand der bevorzugten Ausführungsbeispiele näher illustriert und beschrieben. Dennoch ist die Erfindung nicht auf die offenbarten Beispiele eingeschränkt. Vielmehr können hieraus andere Variationen vom Fachmann abgeleitet werden, ohne den Schutzumfang der Erfindung zu verlassen.

Diese Patentanmeldung beansprucht die Priorität der deutschen Patentanmeldung 102013104195.7.

### Bezugszeichenliste

- 100: Kristall
- 110: erster Arm
- 115: Armlänge
- 116: Armdurchmesser
- 120: zweiter Arm
- 130: dritter Arm
- 140: vierter Arm
- 150: Mittelpunkt
- 160: konkave Hülle

- 200: polymere Lage
- 210: Oberfläche

- 300: optoelektronisches Bauelement
- 310: Gehäuse
- 320: Boden
- 321: erste Kontaktfläche
- 322: zweite Kontaktfläche
- 323: Bonddraht
- 330: Begrenzungsring
- 340: Innenraum
- 350: Reflektorschicht
- 351: Oberseite
- 352: optisch reflektierende Partikel
- 360: Vergussschicht
- 361: Unterseite
- 370: Kontaktbereich

- 400: optoelektronischer Halbleiterchip
- 410: untere Verbindungsschicht
- 420: obere Verbindungsschicht
- 430: Konversionsschicht

- 500: optoelektronisches Bauelement
- 510: Gehäuse
- 520: Boden
- 521: erste Kontaktfläche
- 522: zweite Kontaktfläche
- 523: Bonddraht
- 530: Begrenzungsring
- 540: Innenraum
- 550: Vergussschicht
- 551: Oberseite
- 560: Linse
- 561: Unterseite
- 562: Außenseite
- 570: Kontaktbereich
- 580: Träger

- 600: optoelektronischer Halbleiterchip

## Patentansprüche

1. Verfahren zum Herstellen eines optoelektronischen Bauelements (300, 500)
mit den folgenden Schritten:
- Erzeugen einer ersten Lage (350, 550) eines polymeren Materials;
- Aufbringen von Kristallen (100) auf eine Oberfläche (351, 551) der ersten Lage (350, 550);
- Erzeugen einer zweiten Lage (360, 560) eines polymeren Materials auf der Oberfläche (351, 551) der ersten Lage (350, 550).

2. Verfahren gemäß Anspruch 1,
wobei
- die Kristalle (100) eine konkave Form (160) aufweisen,
- die erste Lage (350, 550) und die zweite Lage (360, 560) mit dem gleichen polymeren Material gebildet sind,
- die Kristalle (100) vor einem Aushärten des Materials der ersten Lage (350, 550) aufgebracht werden,
- die zweite Lage (360, 560) vor einem Aushärten des Materials der ersten Lage (350, 550) erzeugt wird,
- die erste Lage (350, 550) und die zweite Lage (360, 560) voneinander unterschiedliche thermische Ausdehnungskoeffizienten aufweisen,
- zumindest ein Großteil der Kristalle stellenweise von Material der ersten Lage (350, 550) und stellenweise von Material der zweiten Lage (350, 550) umgeben ist, und
- zumindest ein Großteil der Kristalle stellenweise direkt an die erste Lage (350, 550) und die zweite Lage (360, 560) grenzt.

3. Verfahren gemäß einem der vorhergehenden Ansprüche, wobei die Kristalle (100) eine konkave Form (160) aufweisen.

4. Verfahren gemäß einem der vorhergehenden Ansprüche, wobei die Kristalle (100) vor einem Aushärten des Materials der ersten Lage (350, 550) aufgebracht werden.

5. Verfahren gemäß einem der vorhergehenden Ansprüche, wobei die zweite Lage (360, 560) vor einem Aushärten des Materials der ersten Lage (350, 550) erzeugt wird.

6. Verfahren gemäß einem der vorhergehenden Ansprüche, wobei die Kristalle (100) auf die Oberfläche (351, 551) der ersten Lage (350, 550) aufgestreut werden.

7. Verfahren gemäß einem der vorhergehenden Ansprüche, wobei die Kristalle (100) ohne Verwendung eines Dispersions-Additivs aufgebracht werden.

8. Optoelektronisches Bauelement (300, 500)
mit einer ersten Lage (350, 550) eines polymeren Materials
und einer zweiten Lage (360, 560) eines polymeren Materials,
wobei die erste Lage (350, 550) und die zweite Lage (360, 560) aneinander angrenzen,
wobei in einem Kontaktbereich (370, 570) zwischen der ersten Lage (350, 550) und der zweiten Lage (360, 560) Kristalle (100) angeordnet sind.

9. Optoelektronisches Bauelement (300, 500) gemäß dem vorherigen Anspruch,
wobei die Kristalle (100) eine konkave Form (160) aufweisen.

10. Optoelektronisches Bauelement (300, 500) gemäß einem der vorherigen Ansprüche,
aufweisend zumindest einen optoelektronischen Halbleiterchip (400), wobei die erste Lage (350, 550) und/oder die zweite Lage (360, 560) direkt an den optoelektronischen Halbleiterchip (400) grenzen.

11. Optoelektronisches Bauelement (300, 500) gemäß einem der vorherigen Ansprüche,
wobei die erste Lage (350, 550) und/oder die zweite Lage (360, 560) ein Silikon aufweist.

12. Optoelektronisches Bauelement (300, 500) gemäß einem der vorherigen Ansprüche,
wobei die erste Lage (350, 550) und/oder die zweite Lage (360, 560) Polytetrafluorethylen aufweist.

13. Optoelektronisches Bauelement (300, 500) gemäß einem der vorherigen Ansprüche,
wobei die Kristalle (100) eine durchschnittliche Größe von weniger als 0,5 mm, bevorzugt von weniger als 0,2 mm, aufweisen.

14. Optoelektronisches Bauelement (300, 500) gemäß einem der vorherigen Ansprüche,
wobei die Kristalle (100) Zinkoxid aufweisen.

15. Optoelektronisches Bauelement (300, 500) gemäß einem der vorherigen Ansprüche,
wobei die Kristalle (100) als Tetrapoden ausgebildet sind.

16. Optoelektronisches Bauelement (300) gemäß einem der vorherigen Ansprüche,
wobei optisch reflektierende Partikel (352) in das Material der ersten Lage (350) eingebettet sind.

17. Optoelektronisches Bauelement (500) gemäß einem der vorherigen Ansprüche,
wobei die zweite Lage (560) eine optische Linse des optoelektronischen Bauelements (500) bildet.

## Claims

1. Method for producing an optoelectronic component (300, 500),
comprising the following steps:
- producing a first layer (350, 550) of a polymer material;
- applying crystals (100) onto a surface (351, 551) of the first layer (350, 550);
- producing a second layer (360, 560) of a polymer material on the surface (351, 551) of the first layer (350, 550).

2. Method according to claim 1,
wherein
- the crystals (100) have a concave shape (160),
- the first layer (350, 550) and the second layer (360, 560) are formed with the same polymer material,
- the crystals (100) are applied before curing of the material of the first layer (350, 550),
- the second layer (360, 560) is produced before curing of the material of the first layer (350, 550),
- the first layer (350, 550) and the second layer (360, 560) have different thermal expansion coefficients to one another,
- at least a large part of the crystals is enclosed locally by material of the first layer (350, 550) and locally by material of the second layer (350, 550), and
- at least a large part of the crystals locally directly adjoins the first layer (350, 550) and the second layer (360, 560).

3. Method according to one of the preceding claims, wherein the crystals (100) have a concave shape (160).

4. Method according to one of the preceding claims, wherein the crystals (100) are applied before curing of the material of the first layer (350, 550).

5. Method according to one of the preceding claims, wherein the second layer (360, 560) is produced before curing of the material of the first layer (350, 550).

6. Method according to one of the preceding claims, wherein the crystals (100) are scattered onto the surface (351, 551) of the first layer (350, 550).

7. Method according to one of the preceding claims, wherein the crystals (100) are applied without using a dispersion additive.

8. Optoelectronic component (300, 500) comprising a first layer (350, 550) of a polymer material
and a second layer (360, 560) of a polymer material, wherein the first layer (350, 550) and the second layer (360, 560) adjoin one another,
wherein crystals (100) are arranged in a contact region (370, 570) between the first layer (350, 550) and the second layer (360, 560).

9. Optoelectronic component (300, 500) according to the preceding claim,
wherein the crystals (100) have a concave shape (160).

10. Optoelectronic component (300, 500) according to one of the preceding claims,
comprising at least one optoelectronic semiconductor chip (400), wherein the first layer (350, 550) and/or the second layer (360, 560) directly adjoin the optoelectronic semiconductor chip (400).

11. Optoelectronic component (300, 500) according to one of the preceding claims,
wherein the first layer (350, 550) and/or the second layer (360, 560) comprises a silicone.

12. Optoelectronic component (300, 500) according to one of the preceding claims,
wherein the first layer (350, 550) and/or the second layer (360, 560) comprises polytetrafluoroethylene.

13. Optoelectronic component (300, 500) according to one of the preceding claims,
wherein the crystals (100) have an average size of less than 0.5 mm, preferably less than 0.2 mm.

14. Optoelectronic component (300, 500) according to one of the preceding claims,
wherein the crystals (100) comprise zinc oxide.

15. Optoelectronic component (300, 500) according to one of the preceding claims,
wherein the crystals (100) are configured as tetrapods.

16. Optoelectronic component (300) according to one of the preceding claims,
wherein optically reflective particles (352) are embedded in the material of the first layer (350).

17. Optoelectronic component (500) according to one of the preceding claims,
wherein the second layer (560) forms an optical lens of the optoelectronic component (500).

## Revendications

1. Procédé de fabrication d'un composant optoélectronique (300, 500)
comprenant les étapes suivantes :
- production d'une première couche (350, 550) d'une matière polymère ;
- application de cristaux (100) sur une surface (351, 551) de la première couche (350, 550) ;
- production d'une deuxième couche (360, 560) d'une matière polymère sur la surface (351, 551) de la première couche (350, 550).

2. Procédé selon la revendication 1, dans lequel
- les cristaux (100) présentent une forme concave (160),
- la première couche (350, 550) et la deuxième couche (360, 560) sont formées avec la même matière polymère,
- les cristaux (100) sont appliqués avant un durcissement de la matière de la première couche (350, 550),
- la deuxième couche (360, 560) est produite avant un durcissement de la matière de la première couche (350, 550),
- la première couche (350, 550) et la deuxième couche (360, 560) présentent des coefficients de dilatation thermique différents l'un de l'autre,
- au moins une grande partie des cristaux est entourée par endroits de matière de la première couche (350, 550) et par endroits de matière de la deuxième couche (350, 550), et
- au moins une grande partie des cristaux est directement adjacente à la première couche (350, 550) et à la deuxième couche (360, 560).

3. Procédé selon l'une quelconque des revendications précédentes,
dans lequel les cristaux (100) présentent une forme concave (160).

4. Procédé selon l'une quelconque des revendications précédentes, dans lequel les cristaux (100) sont appliqués avant un durcissement de la matière de la première couche (350, 550).

5. Procédé selon l'une quelconque des revendications précédentes, dans lequel la deuxième couche (360, 560) est fabriquée avant un durcissement de la matière de la première couche (350, 550).

6. Procédé selon l'une quelconque des revendications précédentes, dans lequel les cristaux (100) sont dispersés sur la surface (351, 551) de la première couche (350, 550).

7. Procédé selon l'une quelconque des revendications précédentes, dans lequel les cristaux (100) sont appliqués sans utilisation d'un additif de dispersion.

8. Composant optoélectronique (300, 500) comprenant une première couche (350, 550) d'une matière polymère
et une deuxième couche (360, 560) d'une matière polymère,
dans lequel la première couche (350, 550) et la deuxième couche (360, 560) sont adjacentes l'une à l'autre, dans lequel des cristaux (100) sont disposés dans une zone de contact (370, 570) entre la première couche (350, 550) et la deuxième couche (360, 560).

9. Composant optoélectronique (300, 500) selon la revendication précédente,
dans lequel les cristaux (100) présentent une forme concave (160).

10. Composant optoélectronique (300, 500) selon l'une quelconque des revendications précédentes,
présentant au moins une puce à semi-conducteur (400) optoélectronique, dans lequel la première couche (350, 550) et/ou la deuxième couche (360, 560) sont directement adjacentes à la puce à semi-conducteur (400) optoélectronique.

11. Composant optoélectronique (300, 500) selon l'une quelconque des revendications précédentes,
dans lequel la première couche (350, 550) et/ou la deuxième couche (360, 560) présentent un silicone.

12. Composant optoélectronique (300, 500) selon l'une quelconque des revendications précédentes,
dans lequel la première couche (350, 550) et/ou la deuxième couche (360, 560) présentent du polytétrafluoréhtylène.

13. Composant optoélectronique (300, 500) selon l'une quelconque des revendications précédentes,
dans lequel les cristaux (100) présentent une taille moyenne de moins de 0,5 mm, de préférence de moins de 0,2 mm.

14. Composant optoélectronique (300, 500) selon l'une quelconque des revendications précédentes, dans lequel les cristaux (100) présentent de l'oxyde de zinc.

15. Composant optoélectronique (300, 500) selon l'une quelconque des revendications précédentes,
dans lequel les cristaux (100) sont réalisés comme tétrapodes.

16. Composant optoélectronique (300) selon l'une quelconque des revendications précédentes,
dans lequel des particules (352) optiquement réfléchissantes sont incorporées dans la matière de la première couche (350).

17. Composant optoélectronique (500) selon l'une quelconque des revendications précédentes,
dans lequel la deuxième couche (560) forme une lentille optique du composant optoélectronique (500).
